Europäisches Patentamt

European Patent Office

Office européen des brevets

(11) Veröffentlichungsnummer: **0 429 696 A1**

## (12) EUROPÄISCHE PATENTANMELDUNG

(21) Anmeldenummer: 89121924.8

(22) Anmeldetag: 28.11.89

(51) Int. Cl.5: **H01L 29/60**, H01L 21/28

(43) Veröffentlichungstag der Anmeldung:
05.06.91 Patentblatt 91/23

(84) Benannte Vertragsstaaten:
AT BE CH DE ES FR GB GR IT LI LU NL SE
Patentblatt 6

(71) Anmelder: **Siemens Aktiengesellschaft**
**Wittelsbacherplatz 2**
**W-8000 München 2(DE)**

(72) Erfinder: **Ponse, Frederik, Dr.**
**Bahnhofweg 2**
**W-8025 Unterhaching(DE)**
Erfinder: **Platzer, Alfons**
**Portiastrasse 16**
**W-8000 München 90(DE)**
Erfinder: **Belle, Gabriele, Dr.**
**Florastrasse 58**
**W-8000 München 82(DE)**
Erfinder: **Knapek, Erwin, Dr.**
**Franz-Schubert-Strasse 26**
**W-8025 Unterhaching(DE)**

(54) **Feldeffekttransistor mit einem T-Gate.**

(57) Ein Feldeffekttransistor mit einem T-Gate soll einen kleinen Gate-Widerstand aufweisen. Auf der Halbleiter-Oberfläche (1) ist im Bereich des Gates (6) eine Siliziumnitrid-Passivierung (3) vorhanden. Im Gate-Bereich hat diese Siliziumnitrid-Passivierung (3) eine Öffnung. Diese Öffnung im Gate-Bereich ist von der Gate-Metallisierung (6) ausgefüllt. Die Gate-Me- tallisierung (6) liegt außerhalb dieser Öffnung im Gatebereich auf der Siliziumnitrid-Schicht (3) auf, so daß eine Abdichtung zwischen Gate-Metallisierung (6) und Siliziumnitrid-Schicht (3) erzielt und ein gros- ser Gatequerschnitt bei kleiner Gatelänge erreicht ist.

FIG 6

## FELDEFFEKTTRANSISTOR MIT EINEM T-GATE

Die Erfindung betrifft einen Feldeffekttransistor mit einem T-Gate nach dem Oberbegriff des Patentanspruchs 1 und ein Verfahren zu seiner Herstellung.

Feldeffekttransistoren sollen für möglichst hohe Schalt- bzw. Grenzfrequenzen geeignet sein. Dies betrifft sowohl Feldeffekttransistoren auf Silizium-Basis als auch auf III-V und II-VI-Verbindungshalbleitermaterial-Basis. Dabei sollen rauscharme (kleiner als 1,4 dB) Feldeffekttransistoren auch noch im Gigaherzbereich (12 GHz) mit Gatestrukturen kleiner als 0,2 Mikrometern möglich sein. Zu diesem Zweck wird insbesondere ein kleiner Gatewiderstand angestrebt.

Die Herstellung von Galliumarsenid-Mikrowellen-Feldeffekttransistoren ist beschrieben in IEEE Electron Device Letters, Band EDL-4, Nr. 2, Febr. 1983, S. 42-44; J. Vac. Sci. Technol. B 5 (1), Jan/Feb 1987, S. 211-214; IEEE Transaction on Electron Devices, Band ED-32, Nr. 6, Juni 1985, S. 1042-1046; Electronics Letters, 11. Juni 1981, Band 17, Nr. 12, S. 429-430.

Der vorliegenden Erfindung liegt die Aufgabe zugrunde, einen Feldeffekttransistor der eingangs genannten Art anzugeben, der bei kleiner Gatelänge einen kleinen Gate-Widerstand aufweist.

Diese Aufgabe wird erfindungsgemäß durch einen Feldeffekttransistor nach dem Patentanspruch 1 gelöst. Ein vorteilhaftes Verfahren zu seiner Herstellung ist in Patentanspruch 2 angegeben.

Ausgestaltungen und Vorteile der Erfindung sind in der Beschreibung und der Zeichnung erläutert.

Die Erfindung ist insbesondere anwendbar für Galliumarsenid- MESFET und HEMT auf Heterostruktur-Verbindungshalbleitern.

Die Erfindung wird im folgenden anhand der Zeichnung näher erläutert.

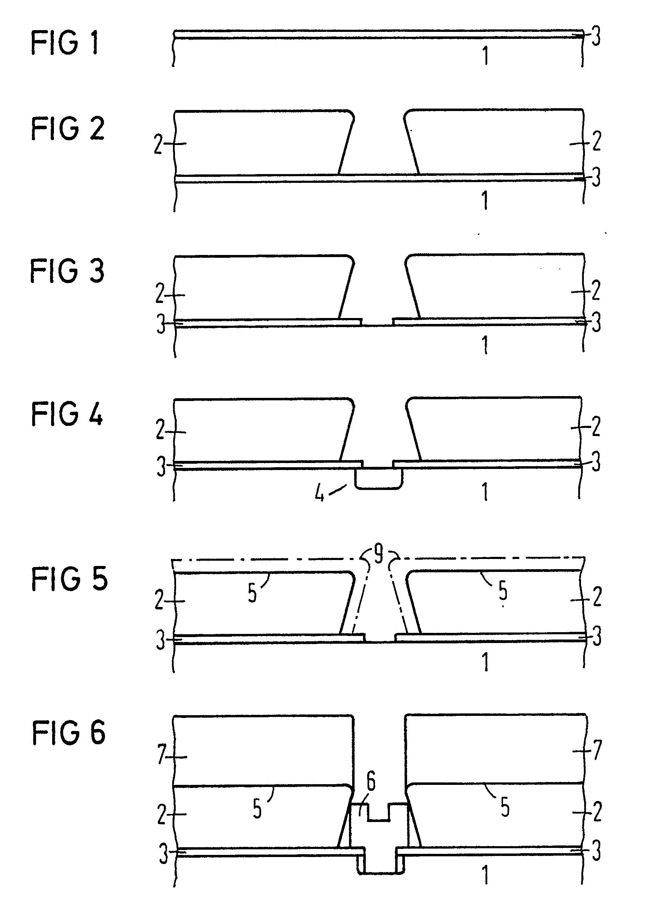

FIG 1 bis 6 erläutern die Herstellung eines Feldeffekttransistors nach der Erfindung.

Gemäß FIG 1 wird ein Galliumarsenid-Substrat 1 mit einer Siliziumnitrid-Schicht mit einer Dicke von 50 nm beschichtet. Diese Siliziumnitrid-Schicht 3 stellt eine Schutzschicht dar und kann als Sputter-Nitrid aufgebracht werden. Anschließend werden selektive Kontakt- und Kanal-Implantationen zur Erzeugung der in der Zeichnung nicht dargestellten aktiven Kontakt-Schichten (Si-Implantation) durchgeführt. Anschließend wird ein Fotolack 2 aufgebracht (FIG 2). Der Fotolack 2 kann ein Ein-, Zwei- oder Drei-Lagen-Fotolack sein. Der Fotolack 2 kann mittels Elektronenstrahlschreiber oder mittels lichtoptischer Lithographie belichtet werden Bei Gatelängen unter 0,4 μm werden vorteilhaft Elektronenlacke (z.B. PMMA) verwendet.

Bei Gatelängen um 0,4 μm lassen sich vorteilhaft auch optische Fotolacke AZ 5206 bei Lackdikken von 0,6 μm im image-reversalmode verwenden.

Nach Entwicklung soll sich eine Lackstruktur mit senkrechten oder überhängenden Lackflanken ergeben (FIG 2).

FIG 3 zeigt die Struktur eines Halbleiterbauelements vor Gate-Recess. Dabei wird das Siliziumnitrid 3 im Gatebereich geätzt. Dieser Prozeßschritt wird anisotrop auf dem RIE-System 4000 von Tepla durchgeführt. Dabei wird in $CF_4$-Atmosphäre bei 50 W Leistung das Nitrid geätzt.

FIG 4 zeigt eine Struktur ähnlich zur Struktur nach FIG 3, außer daß nach dem Ätzen des Siliziumnitrids 3 noch ein Gate-Recess-Graben 4 naßchemisch geätzt wird. Wegen der Verwendung der Si liziumnitrid-Schicht 3 im Zusammenhang mit dem anisotropen RIE-Ätzen ist die seitliche Unterätzung beim Gate-Recess 4 wohldefiniert und unabhängig von der Haftung des Fotolacks 2.

Unabhängig davon, ob ein Gate-Recess 4 vorhanden ist oder nicht, wird in einer vorteilhaften Ausgestaltung der Erfindung anschließend an FIG 3 bzw. an FIG 4 der Fotolack 2 erneut entwickelt. Wenn dabei gemäß FIG 5 vor diesem erneuten Entwickeln der Fotolack 2 die äußere Form 9 hatte, so hat dieser Fotolack 2 nach diesem erneuten Entwickeln die äußere Form 5. Dadurch wird also die Fotolackkante im Bereich der Gate-Struktur des Fotolacks 2 zurückgesetzt. Dadurch wird also die Gate-Struktur innerhalb des Fotolacks 2 vergrößert, was schließlich zu einem größeren Querschnitt der Gate-Metallisierung und damit zu einem noch kleineren Gatewiderstand führt. Die aktive Gatelänge bleibt dabei entsprechend der Öffnung im Silizium-Nitrid auf dem gewünschten kleinen Wert. Diese Vergrößerung kann auch durch isotropes Ätzen der Fotolackschicht im $O_2$-Plasma erreicht werden. Schließlich wird gemäß FIG 6 die Gate-Metallisierung 6 aufgebracht. Mittels Abhebetechnik wird das überflüssige Gate-Metall 7, welches sich oberhalb des Fotolacks 2 befindet, zusammen mit diesem Fotolack 2 entfernt. Eine Abhebetechnik (Lift-off-Technik) wird häufig bei der Herstellung von Halbleiterbauelementen verwendet (US-PS 4 377 030).

Bei ausreichend überhängenden Lackprofilen kann auf das Aufweiten der Fotolacköffnung verzichtet werden.

Die Gate-Metallisierung 6 wird vorteilhafterweise aufgedampft. Die Gate-Metallisierung 6 bildet ein T-Gate. Die Gate-Metallisierung 6 kann auf der Oberfläche des Halbleiters auch als Sinter-Gate ausgebildet werden. Die Gate-Metallisierung 6 besitzt einen großen Querschnitt, liegt auf der passivierenden Siliziumnitrid-Schutzschicht 3 auf. Dadurch wird eine zusätzliche Passivierung des Gate-Bereichs erzielt. Obwohl bei der Herstellung eines Sintergates der Gate-Widerstand nach dem Sintern etwas vergrößert ist, ist das T-Gate gemäß der Erfindung sehr wichtig wegen seines großen Querschnitts und wegen seiner Abdichtung an der Kante zwischen der Gate-Metallisierung 6 und der Gate-Öffnung in der Siliziumnitrid-Schutzschicht 3. Die Gate-Metallisierung 6 füllt nämlich die Gate-Öffnung in der Siliziumnitridschicht 3 aus und bedeckt außerhalb dieser Gate-Öffnung die Siliziumnitrid-Schutzschicht so, daß eine Abdichtung zwischen Gate-Metallisierung 6 und Siliziumnitridschicht 3 erzielt ist. Beim Aufbringen der Gate-Metallisierung wächst das Gate 6 auf der Nitridschicht 3 in Form eines T-Gates mit auf, was zu kleineren Gatewiderständen führt.

Das erneute Entwickeln des Fotolacks 2 gemäß FIG 5 ist vorteilhaft, für die Erfindung jedoch nicht unbedingt erforderlich. Bei geeigneter Bedampfung wächst das Gate auch ohne Aufweitung der Fotolacköffnung zuverlässig auf der Silizium-Nitridschicht mit auf. Das erneute Entwickeln des Fotolacks 2 gemäß FIG 5 erfolgt vorteilhaft mit Sprühentwickler oder durch isotropen Abtrag im $O_2$-Plasma. Erzeugen der Fotolackstruktur gemäß FIG 2 erfolgt vorteilhafterweise mit image-reversal-Methode. Der Querschnitt der Gate-Metallisierung 6 ist größer als es der aktiven Gate-Länge entsprechen würde.

**Ansprüche**

1. Feldeffekttransistor mit einem T-Gate,
**dadurch gekennzeichnet,** daß auf der Halbleiter-Oberfläche im Bereich des Gates eine Siliziumnitrid-Passivierung vorhanden ist, daß im Gate-Bereich diese Siliziumnitrid-Passivierung eine Offnunghat, daß diese Öffnung von der Gate-Metallisierung ausgefüllt ist und daß die Gate-Metallisierung außerhalb dieser Öffnung auf der Siliziumnitrid-Schicht aufliegt, so daß eine Abdichtung zwischen Gate-Metallisierung und Siliziumnitrid-Schicht erzielt und ein großer Gatequerschnitt bei kleiner Gatelänge erreicht ist.

2. Verfahren zur Herstellung eines Feldeffekttransistors mit einem T-Gate nach Anspruch 1,
**dadurch gekennzeichnet,** daß

    a) das Halbleiter-Substrat mit einer Siliziumnitrid-Schicht versehen wird,

    b) auf der Siliziumnitrid-Schicht ein Fotolack mit einer Struktur im Gatebereich erzeugt wird,

    c) in dieser Struktur des Fotolacks im Gate-Bereich mittels anisotropem Atzen die Siliziumnitrid-Schicht geätzt wird,

    d) der Fotolack erneut entwickelt wird,

    e) die Gate-Metallisierung mittels Abhebetechnik erzeugt wird.

FIG 1

FIG 2

FIG 3

FIG 4

FIG 5

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | IBM TECHNICAL DISCLOSURE BULLETIN, Band 30, Nr. 2, Juli 1987, Seite 888, New York, US; "Passivated recess-gate structure"<br>* Insgesamt * | 1 | H 01 L 29/60<br>H 01 L 21/28 |
| A | IDEM | 2 | |
| X | EP-A-0 314 877 (SIEMENS AG BERLIN UND MÜNCHEN)<br>* Figur 16; Zusammenfassung; Spalte 3, Zeilen 4-29 * | 1 | |
| X | PATENT ABSTRACTS OF JAPAN, Band 10, Nr. 236 (E-428)[2292], 15. August 1986; & JP-A-61 69 175 (NEC CORP.) 09-04-1986<br>* Insgesamt * | 1 | |
| X | JOURNAL OF THE ELECTROCHEMICAL SOCIETY, Band 134, Nr. 10, Oktober 1987, Seiten 2613-2616, Manchester, NH, US; C.J. WU et al.: "Narrow recess HEMT technology"<br>* Zusammenfassung; Figur 3; Seite 2614; Spalte 1, Zeile 4 - Seite 2615, Spalte 1, Zeile 6 * | 1 | RECHERCHIERTE SACHGEBIETE (Int. Cl.5)<br><br>H 01 L 29<br>H 01 L 21 |

Der vorliegende Recherchenbericht wurde für alle Patentansprüche erstellt

| Recherchenort | Abschlußdatum der Recherche | Prüfer |
|---|---|---|
| DEN HAAG | 11-05-1990 | MIMOUN B.J. |

EPO FORM 1503 03.82 (P0403)